# EUROPEAN PATENT SPECIFICATION

(11) **EP 0 613 170 B1**
(45) Date of publication and mention of the grant of the patent: **14.05.1997**
(21) Application number: 93102409.5
(22) Date of filing: 16.02.1993
(51) Int. Cl.: H01J 37/317

(54) **Method and apparatus for fabrication of thin film semiconductor devices using non-planar, exposure beam lithography**
Verfahren und Gerät zur Herstellung von Dünnfilm-Halbleitervorrichtungen mittels nicht-planarer Strahlbelichtungslithographie
Méthode et appareil pour la fabrication de dispositifs semi-conducteurs en film mince utilisant la lithographie non-planaire par exposition à un faisceau

(43) Date of publication of application: 31.08.1994
(73) Proprietor: SARCOS, INC., Salt Lake City Utah 84108 (US)
(72) Inventor: Jacobsen, Stephen C., Salt Lake City, Utah 84102 (US)
(74) Representative: Grünecker, Kinkeldey, Stockmair & Schwanhäusser Anwaltssozietät

(56) References cited:
- US-A- 4 514 253
- US-A- 5 106 455
- PATENT ABSTRACTS OF JAPAN vol. 10, no. 99 (E-396)16 April 1986 & JP-A-60 240125

## Description

### BACKGROUND OF THE INVENTION

This invention relates to a method for fabricating semiconductor devices utilizing exposure beam lithography over non-planar surfaces of the devices.

Exposure beam treatment of now planar surfaces is known from US-A-5 106 455. Lithographic techniques, for instance for fabrication of a thin film transistor according to US-A-4 514 253 have been utilized for some time in the manufacture especially of integrated circuit boards, semiconductor devices and related products. The products manufactured, of course, have typically included planar surface areas to which the lithographic techniques were applied. Such techniques have proven extremely effective in the precise manufacturing and formation of very small details in the product. However, attempts to apply such techniques to other than planar surfaces have proven difficult, if not unachievable, to the present time. As a result, the versatility available in semiconductor devices and constructs has been limited to use of essentially planar components.

### SUMMARY OF THE INVENTION

It is an object of the invention to provide a method for fabricating thin film semiconductor devices utilizing lithographic techniques applied over nonplanar devices.

This object is solved according to the invention with a method according to claim 1.

An apparatus for executing the invention includes a chamber, a beam generator disposed in the chamber for producing and directing an exposure beam towards a work location, a chuck disposed in the chamber for holding and positioning a workpiece or volumetric substrate at the work location, and a first element, to which the chuck is attached, responsive to first control signals for selectively moving the chuck, and thus the substrate, in a first degree of freedom of movement, to thereby expose different areas of the substrate to the beam. Also included are a second element, to which the first element is attached, responsive to second control signals for selectively moving the first element, and thus the chuck and substrate, in a second degree of freedom of movement to thereby expose still other areas of the substrate to the beam, and a controller for developing and supplying the first control signals to the first element and the second control signals to the second element.

Advantageously, the chamber is a vacuum chamber and the exposure beam is an electron beam. With this apparatus, a substrate may be covered with one or more layers of one or more semiconductor materials such as silicon and an insulator layer. The layers would then be covered with an electron beam resist, and the resist set by applying heat thereto. The substrate may then be placed in the chuck and the beam directed toward the substrate as the substrate is moved in some predetermined manner by the first and second elements to thereby expose to the electron beam a semiconductor device pattern in the resist. After developing the exposed resist, the desired pattern could then be etched in the workpiece by applying an appropriate etchant. The pattern or portions thereof may be doped with selected charge types (N-type or P-type) to produce a desired semiconductor device. Selected conductor patterns could be applied to the substrate, utilizing the apparatus, to thus provide needed electrical connections for operating the device. In this manner, a non-planar semiconductor pattern could be formed in the volumetric or three-dimensional substrate in a precise and efficient manner.

### BRIEF DESCRIPTION OF THE DRAWINGS

The above and other objects, features and advantages of the invention will become apparent from a consideration of the following detailed description presented in connection with the accompanying drawings in which:
FIG. 1 is a schematic view of apparatus for the non-planar treatment of a workpiece using lithographic techniques, for performing the method according to the present invention;
FIG. 2 is a perspective view of a cylindrical workpiece etched with a semiconductor pattern using the apparatus of FIG. 1; and
FIG. 3 is a perspective view of a cylinder workpiece formed with a conductor pattern using the apparatus of FIG. 1.

### DETAILED DESCRIPTION

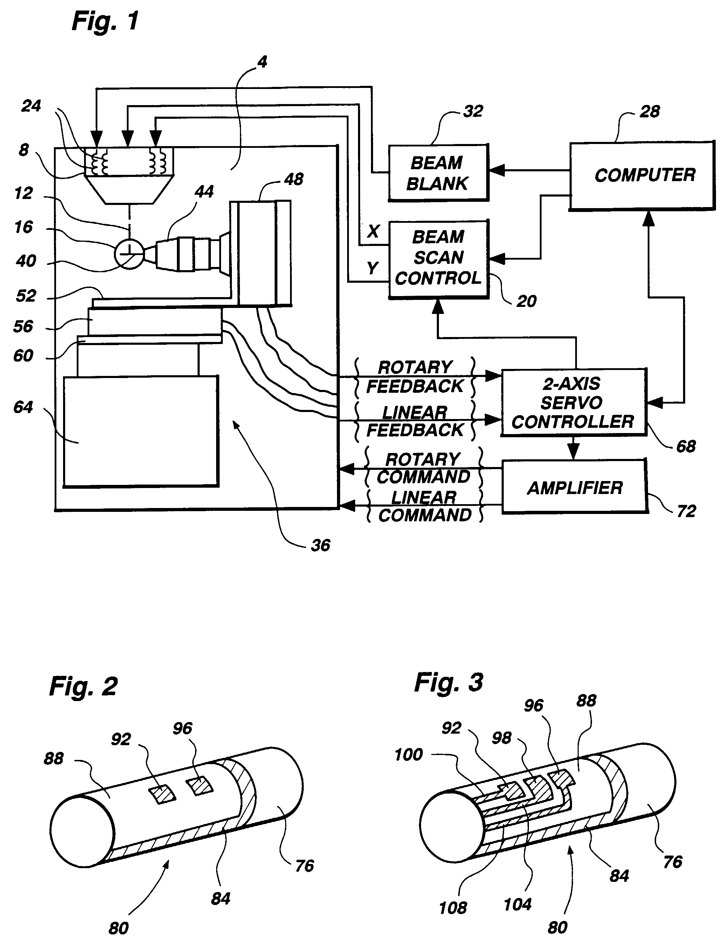

Referring to FIG. 1, there is shown an electron beam vacuum chamber 4 in which is disposed a conventional electron beam generator 8 of a scanning electron microscope. The electron beam generator 8 produces an electron beam 12 which is directed towards a work area 16. The direction of the electron beam 12 is under control of a beam scan control unit 20 and may be changed or caused to move along two orthogonal axes (designated the x and y axes) laterally of the beam. The beam scan control unit 20 applies analog signals to coils 24 in the electron beam generator 8 to control the direction of the electron beam 12, all in a conventional manner. The beam scan control unit 20 might illustratively be a digital-to-analog converter which receives digital signals from a computer 28 identifying the x and y coordinates which the electron beam 12 is to have. The computer 28, which controls the overall operation of the system of FIG. 1, could illustratively be a Compaq 386 computer.

A conventional beam blanking circuit 32 is provided to operate under control of the computer 28 to vary the intensity of electron beam 12. This intensity can be varied from zero (no beam) up to some predetermined upper limit intensity. Such operation is well known.

Also disposed in the vacuum chamber 4 is a workpiece or substrate positioning mechanism 36 for selectively moving and positioning a workpiece or substrate 40 which, in the embodiment shown in FIG. 1, is a cylindrical bar. The substrate 40 is held by conventional chuck 44 which, in turn, is rotatably held by a rotary motorized stage 48. The rotary stage 48 is mounted on a bracket 52 which, in turn, is mounted on a linear motorized stage 56 which is moveable linearly on a track 60. The track 60 is mounted on a base 64 which may be manually moved and positioned in the chamber 4 as desired.

Both the rotary stage 4 and the linear stage 56 operate under control of the computer 28. The rotary stage 48 selectively causes rotation of the chuck 44 which, in turn, causes the substrate 40 to rotate about an axis which is generally perpendicular to the electron beam 12, as shown. The linear stage 56, when it moves linearly on the track 60, carries with it the bracket 52, rotary stage 48, chuck 44 and thus the substrate 40, in the direction of travel of the linear stage which is a direction parallel to the axis of rotation of the substrate. In this manner, the substrate 40 may be selectively moved under the electron beam 12 both rotationally and linearly to cause the electron beam to fall or impinge on different convex surface areas of the substrate. In addition, the electron beam 12 can itself be caused to move orthogonally relative to the location of the workpiece under control of the beam scan control unit 20. The rotary motorized stage 48 might illustratively be a 360 degree continuous rotation stage, No. 345,341, manufactured by Klinger, and the linear motorized stage 56 might illustratively be a translational stage, No. MF04 also manufactured by Klinger.

Control of the operation of the rotary stage 48 and the linear stage 56 is effectuated by a two-axis servo controller 68 and an amplifier 72, again under control of the computer 28. The computer 28 supplies signals to the controller 68 in the form of commands for movement of the rotary stage 48 and linear stage 56. These signals are supplied to the amplifier 72 which then supplies rotary command signals to the rotary stage 48 and linear command signals to the linear stage 56 to cause the desired operation of the stages. As the rotary stage 48 and linear stage 56 are operated, both develop feedback signals representing the respective degrees of movement of the stages and these signals are supplied to the controller 68 which, in turn, supplies the signals to the computer 28. The computer 28 compares the feedback signals with the previously issued command signals to determine if the movement of the stages was in accordance with the command signals, and to make appropriate corrections if needed. The two-axis servo controller 68 might illustratively be a Galil DMC-620 controller and the amplifier 72 might illustratively be a Galil ICB-960 amplifier.

FIG. 2 is a perspective view of a cylindrical bar 76 on which a semiconductor device, namely a field-effect transistor FET 80, has been deposited and etched using the apparatus of FIG. 1. The device includes a layer of semiconductor material 84 overlaid with an insulator layer 88, in which are etched a source region 92 and drain 96 region, using an electron beam lithographic process as will be described momentarily.

FIG. 3 shows the bar 76 formed with conductors 100, 104 and 108 for connecting to the source 92, gate 98 and drain 96 respectively of the transistor device 80.

Although two degrees of freedom of movement of the substrate 40 is possible with the apparatus of FIG. 1, clearly other degrees of freedom of movement could also be provided for the substrate. For example, an additional linear degree of freedom of movement could be provided, the direction of which would be generally perpendicular to both the electron beam 12 and the direction of movement of the linear stage 56. This could be done by mounting the track 60 on another linear stage which would be moveable in a direction which was at right angles to the direction and movement of the stage 56. Also, the bracket 52 could be mounted on another rotational stage to allow rotation of the bracket and thus the substrate 40 about an axis generally parallel to the electron beam 12 to thereby provide two rotational degrees of freedom of movement for the substrate. In all, three rotational degrees of freedom of movement could be provided, along with three linear degrees of freedom of movement (although movement toward and away from the electron beam generator 8 in a linear fashion would probably not be too useful), or any combination thereof.

Although the apparatus of FIG. 1 utilizes an electron beam 12, it should be understood that the apparatus could be provided for directing a laser beam, ion beam, or an x-ray beam, toward a substrate in the same manner as that described for the electron beam.

An illustrative lithographic process for use with the apparatus of FIG. 1 to produce the FET 80 of FIGS. 2 and 3 on the cylinder 76 will next be described. The cylinder 76, which might illustratively be quartz, silica, sapphire, or other nonconductive material, is cleaned using a solvent such as acetone and two-propanol, or using a hydrogen peroxide cycle. A layer 84 of semiconductor material such as P-type doped silicon is then applied to the cylinder 76 using conventional application techniques such as sputtering, chemical vapor deposition, dip coating or plating. The thickness of the layer might illustratively be from 200 nm to 700 nm (2,000 to 7,000 Angstroms), and is shown as overlying only part of the cylinder 76. Next, an insulator material 88 is applied over the semiconductor layer 84, again by sputtering, chemical vapor deposition, dip coating, or plating, to a thickness of from 200 nm to 300 nm (2,000 to 3,000 Angstroms.) The insulator material might illustratively be silicon nitride, silicon dioxide, or some combination of the two. At this point, it would be desirable to coat the cylinder 76 with an adhesion promoter such as HMDS which improves the ability of electron beam resist to adhere to the surface. Thereafter an electron beam resist would be applied to the cylinder 76 to overly the insulator layer 88--this could be accomplished by simply dipping the cylinder in a solution of the resist.

The electron beam resist is then set by soft-baking the cylinder in a convection oven, for example, for about 30 minutes at about 80 degrees centigrade. The cylinder is then placed in the chuck 44 (FIG. 1) and then the electron beam generator 8 and mechanism 36 are operated to expose the cylinder to the electron beam 12 in the desired pattern. For example, the cylinder 76 could be moved linearly and rotationally to expose first the region 92 and then the region 96 shown in FIG. 2. This could be done by moving the cylinder 76 axially the width of region 92, rotating the cylinder slightly and then moving the cylinder in the opposite direction again the width of the region 92, again rotating the cylinder slightly and moving the cylinder in the opposite direction again, etc. until the entire region had been exposed to the electron beam. The same process could be followed for exposing region 96.

After exposure of the desired pattern is completed, the exposed resist is developed, during which the resist overlying the pattern, i.e., regions 92 and 96, is washed away (positive lithography). The cylinder 76 is then baked in a convection oven, again for about 30 minutes at 80 degrees centigrade, for example. The cylinder is now ready for etching which is carried out by exposing the cylinder to an appropriate etching agent. In positive lithography, the pattern or two regions 92 and 96 would be etched directly for example by using buffered hydrofluoric acid to remove insulator from the regions, down to the semiconductor layer 84. Following the etching step, the remaining electron beam resist is removed and the cylinder is ready for the next step in the fabrication process.

To produce the desired transistor, in this case a field-effect transistor, the regions 92 and 96 of the semiconductor material 84 are doped, for example, with phosphorous to produce N-type doped source 92 and drain 96 regions, in the already P-type doped silicon layer 84.

The next step in the process is to provide a conductor pattern, such as shown in FIG. 3, on the insulator material 88 to allow for applying electrical signals to and receiving electrical signals from the transistor 80. This is done by applying a layer of aluminum or other conductive material to the cylinder 76 such as by sputtering, chemical vapor deposition, etc. to a thickness of about 300 nm (3,000 Angstroms). Electron beam resist is then applied over the layer of conductive material and set as before described. The cylinder is placed in the chuck 44 and the electron beam generator and mechanism 36 operated to expose the cylinder to the electron beam 12 to all but the conductor patterns 100, 104, and 108 as shown in FIG. 3 (negative lighography). After exposure is completed, the exposed electron beam resist is developed and washed away leaving resist overlying only the conductor patterns. That part of the aluminum layer from which the resist was washed away is then etched, i.e., removed, leaving the aluminum in the conductor patterns 100, 104 and 108 as shown in FIG. 3. The resist on the remaining aluminum is then removed to yield the FET transistor shown in FIG. 3, having a source region 92, drain region 96 and gate region 98, all connected respectively by conductors 100, 108 and 104 to one end of the cylinder 76. The conductor patterns shown in FIG. 3 could alternatively have been formed using deposition of conductor material onto resist-etched-away patterns on the insulator material, in a well-known manner.

Although the fabrication of a specific semiconductor device was described and shown in FIGS. 2 and 3, it is apparent that a variety of semiconductor devices or other solid state electronic devices could be formed on volumetric substrates such as the cylinder 76 in FIGS. 2 and 3, using the method of the present invention.

It is to be understood that the above-described arrangements are only illustrative of the application of the principles of the present invention. Numerous modifications and alternative arrangements may be devised by those skilled in the art without departing from the scope of the claims.

## Claims

1. A method for etching a semiconductor device pattern (80) on a generally convex surface of a workpiece (40,76) comprising:
(a) applying a semiconductor material (84) to the surface of the workpiece (40, 76),
(b) applying a resist (88),
(c) setting the resist,
(d) directing an exposure beam (12) toward the workpiece (40, 76),
(e) moving the workpiece (40, 76) in at least two degrees of freedom of movement relative to the beam to expose said semiconductor device pattern (80) in the resist to the beam (12),
(f) developing the exposed resist,
(g) etching the pattern on the material over which the exposed resist was located, and
(h) removing the remaining resist.

2. The method as in claim 1, further comprising the step of
(i) applying an insulator material (88) over the semiconductor material (84).
after step (a) and before step (b).

3. A method as in claim 1 or 2 further including the steps of
(j) doping selected portions of the pattern with a selected electrical charge type, and
(k) applying conductive material to the workpiece (40, 76) to contact selected portions of the pattern.

4. A method as in claim 3 wherein step (k) comprises
(l) applying the conductive material over the insulator material (88) and the pattern,
(m) applying a resist over the conductive material ,
(n) setting the resist,
(o) directing an exposure beam toward the workpiece (40, 76),
(p) moving the workpiece (40, 76) in at least two degrees of freedom of movement relative to the beam to expose a predetermined conductor pattern (100, 104, 108) in the resist to the beam,
(q) developing the exposed resist on the conductive material,
(r) etching the conductor pattern on the conductive material over which the exposed resist was located, and
(s) removing the remaining resist from the conductive material.

5. A method as in claim 4 further including the step of
(t) bonding electrical leads to selected locations on the conductive material of the conductor pattern (100, 104, 108).

6. A method as in claim 2, wherein said workpiece (40, 76) is made of electrically insulative material.

7. A method as in claim 6 wherein said workpiece (40, 76) is material selected from the group consisting of quartz, silica, and sapphire.

8. A method as in claim 2, wherein said material applying steps (a), (i) and (1) comprise sputtering the material to coat the workpiece (40, 76).

9. A method as in claim 4, wherein said applying steps (a), (i), (b), (1) and (m) comprise dipping the workpiece in solutions of the material being applied.

10. A method as in claim 2, wherein said material applying steps (a), (i) and (1) comprise vapor deposition of the material onto the workpiece.

11. A method as in claim 2, wherein step (a) comprises applying silicon to the workpiece.

12. A method as in claim 11, wherein step (i) comprises applying a material selected from the group consisting of silicon nitride and silicon dioxide.

13. A method as in claim 2, wherein the exposure beam (12) is an electron beam.

14. A method as in claim 2, wherein the exposure beam (12) is an ion beam.

15. A method as in claim 2, wherein the exposure beam (12) is a laser beam.

16. A method as in claim 2, wherein the exposure beam (12) is an x-ray beam.

17. A method as in claim 2, wherein said moving steps comprise the steps of rotating the workpiece about an axis generally perpendicular to the beam (12), and moving the workpiece linearly in a direction parallel to the axis.

18. A method as in claim 1, wherein said semiconductor device is a thin film semiconductor device and wherein step (a) comprises applying one or more layers of one or more semiconductor material to surfaces of the workpiece.

19. A method as in claim 18 further including the steps of applying conductive material over the layers at preselected locations.

20. A method as in claim 19, wherein step (e) comprises moving the workpiece linearly in a direction generally parallel to said axis.

21. A method as of one of claims 1-20, wherein in step (e) said substrate is moved in the pathway of said exposure beam, to thereby expose a predetermined microcircuit pattern in the resist.

## Patentansprüche

1. Ein Verfahren zum Ätzen eines Halbleitervorrichtungsmusters (80) auf einer im allgemeinen konvexen Oberfläche eines Werkstücks (40, 76), umfassend:
(a) Vorsehen eines Halbleitermaterials (84) auf der Oberfläche des Werkstücks (40, 76),
(b) Aufbringen eines Resists (88),
(c) Anziehenlassen des Resists,
(d) Richten eines Belichtungsstrahls (12) auf das Werkstück (40, 76),
(e) Bewegen des Werkstücks (40, 76) in wenigstens zwei Bewegungsfreiheitsgraden relativ zu dem Strahl zur Belichtung des Halbleitervorrichtungsmusters (80) in dem Resist mit dem Strahl (12),
(f) Entwickeln des belichteten Resists,
(g) Ätzen des Musters an dem Material, über dem der belichtete Resist vorhanden war, und
(h) Entfernen des verbleibenden Resists.

2. Das Verfahren nach Anspruch 1, weiter mit dem Schritt
(i) des Aufbringens eines Isolatormaterials (88) über dem Halbleitermaterial (84) nach dem Schritt (a) und vor dem Schritt (b).

3. Ein Verfahren nach Anspruch 1 oder 2, weiter mit den Schritten des
(j) Dotierens von ausgewählten Bereichen des Musters mit einem ausgewählten elektrischen Ladungstyp, und
(k) des Aufbringens von leitfähigem Material auf das Werkstück (40, 76) zum Kontaktierten ausgewählter Bereiche des Musters.

4. Ein Verfahren nach Anspruch 3, wobei der Schritt (k) umfaßt
(l) Aufbringen des leitfähigen Materials über dem Isolatormaterial (88) und dem Muster,
(m) Aufbringen eines Resists über dem leitfähigen Material,
(n) Anziehenlassen des Resists,
(o) Richten eines Belichtungsstrahls auf das Werkstück (40, 76),
(p) Bewegen des Werkstücks (40, 76) in wenigstens zwei Bewegungsfreiheitsgraden relativ zu dem Strahl zur Belichtung eines vorbestimmten Leitermusters (100, 104, 108) in dem Resist mit dem Strahl,
(q) Entwickeln des belichteten Resists auf dem leitfähigen Material,
(r) Ätzen des Leitermusters auf dem leitfähigen Material, über dem der belichtete Resist vorhanden war, und
(s) Entfernen des verbleibenden Resists von dem leitfähigen Material.

5. Ein Verfahren nach Anspruch 4, weiter mit dem Schritt des
(t) Bondens elektrischer Zuleitungen an ausgewählte Stellen auf dem leitfähigen Material des Leitermusters (100, 104, 108).

6. Ein Verfahren nach Anspruch 1, wobei das Werkstück (40, 76) aus elektrisch isolierendem Material hergestellt ist.

7. Ein Verfahren nach Anspruch 6, wobei das Werkstück (40, 76) aus der aus Quarz, Siliziumoxid und Saphir bestehenden Gruppe ausgewählt ist.

8. Ein Verfahren nach Anspruch 2, wobei die Materialaufbringungsschritte (a), (i) und (1) ein Aufstäuben des Materials zur Beschichtung des Werkstücks (40, 76) umfassen.

9. Ein Verfahren nach Anspruch 4, wobei die Aufbringungsschritte (a), (i), (b), (1) und (m) ein Eintauchen des Werkstücks in Lösungen des aufzubringenden Materials umfassen.

10. Ein Verfahren nach Anspruch 2, wobei die Materialaufbringungsschritte (a), (i) und (1) eine Gasphasenablagerung des Materials auf das Werkstück umfassen.

11. Ein Verfahren nach Anspruch 2, wobei Schritt (a) die Aufbringung von Silizium auf das Werkstück umfaßt.

12. Ein Verfahren nach Anspruch 11, wobei Schritt (i) eine Aufbringung von aus der aus Siliziumnitrid und Siliziumdioxid bestehenden Gruppe ausgewähltem Material umfaßt.

13. Ein Verfahren nach Anspruch 2, wobei der Belichtungsstrahl (12) ein Elektronenstrahl ist.

14. Ein Verfahren nach Anspruch 2, wobei der Belichtungsstrahl (12) ein Ionenstrahl ist.

15. Ein Verfahren nach Anspruch 2, wobei der Belichtungsstrahl (12) ein Laserstrahl ist.

16. Ein Verfahren nach Anspruch 2, wobei der Belichtungsstrahl (12) ein Röntgenstrahl ist.

17. Ein Verfahren nach Anspruch 2, wobei die Bewegungsschritte den Schritt des Drehens des Werkstücks um eine zu dem Strahl (12) im allgemeinen senkrechte Achse und des Bewegens des Werkstücks linear in einer Richtung parallel zu der Achse umfassen.

18. Ein Verfahren nach Anspruch 1, wobei die Halbleitervorrichtung eine Halbleiterdünnfilmvorrichtung ist, und wobei Schritt (a) die Aufbringung von einer oder mehreren Schichten eines oder mehrerer Halbleitermaterialien auf Oberflächen des Werkstücks umfaßt.

19. Ein Verfahren nach Anspruch 18, das weiter den Schritt des Aufbringens von leitfähigem Material über den Schichten an vorbestimmten Lagen enthält.

20. Ein Verfahren nach Anspruch 19, wobei Schritt (e) ein Bewegen des Werkstücks linear in einer Richtung im allgemeinen parallel zu der Achse umfaßt.

21. Ein Verfahren nach einem der Ansprüche 1-20, wobei in Schritt (e) das Substrat in dem Weg des Belichtungsstrahls bewegt wird, um dadurch ein vorbestimmtes Mikroschaltungsmuster in dem Resist zu belichten.

## Revendications

1. Procédé pour graver une configuration (80) de dispositif semi-conducteur sur une surface généralement convexe d'une pièce de travail (40, 76) comportant les étapes suivantes :
(a) application d'un matériau semi-conducteur (84) sur la surface de la pièce de travail (40,76),
(b) application d'un vernis de masquage (88),
(c) fixation du vernis de masquage,
(d) orientation d'un faisceau d'exposition (12) vers la pièce de travail (40,76),
(e) déplacement de la pièce de travail (40, 76) selon au moins deux degrés de liberté de mouvement par rapport au faisceau pour exposer ladite configuration (80) de dispositif semi-conducteur dans le vernis de masquage au faisceau (12),
(f) développement du vernis de masquage exposé,
(g) gravure de la configuration sur le matériau au-dessus duquel le vernis de masquage exposé était situé, et
(h) élimination du vernis de masquage restant.

2. Procédé selon la revendication 1, comportant en outre l'étape suivante :
(i) application d'un matériau isolant (88) sur le matériau semi-conducteur (84),
après l'étape (a) et avant l'étape (b).

3. Procédé selon la revendication 1 ou 2, comportant en outre les étapes suivantes :
(j) dopage de parties sélectionnées de la configuration avec un type de charge électrique sélectionnée, et
(k) application d'un matériau conducteur à la pièce de travail (40, 76) pour venir en contact avec des parties sélectionnées de la configuration.

4. Procédé selon la revendication 3, dans lequel l'étape (k) comporte les étapes suivantes :
(l) application du matériau conducteur sur le matériau isolant (88) et la configuration,
(m) application d'un vernis de masquage sur le matériau conducteur,
(n) fixation du vernis de masquage,
(o) orientation d'un faisceau d'exposition vers la pièce de travail (40, 76).
(p) déplacement de la pièce de travail (40, 76) selon au moins deux degrés de liberté par rapport au faisceau pour exposer une configuration de conducteurs prédéterminée (100, 104, 108) dans le vernis de masquage au faisceau,
(q) développement du vernis de masquage exposé sur le matériau conduceur,
(r) gravure de la configuration des conducteurs sur le matériau conducteur sur lequel le vernis de masquage était situé, et
(s) élimination du vernis de masquage restant du matériau conducteur.

5. Procédé selon la revendication 4, comportant en outre l'étape suivante :
(t) connexion de fils électriques à des emplacements choisis sur le matériau conducteur de la configuration des conducteurs (100, 104, 108).

6. Procédé selon la revendication 2, dans lequel ladite pièce de travail (40, 76) est en matériau électriquement isolant.

7. Procédé selon la revendication 6, dans lequel ladite pièce de travail (40, 76) est en matériau sélectionné dans un groupe composé de quartz, silice et saphir.

8. Procédé selon la revendication 2, dans lequel lesdites étapes (a), (i) et (1) d'application du matériau comportent la pulvérisation du matériau pour recouvrir la pièce de travail (40, 76).

9. Procédé selon la revendication 4, dans lequel lesdites étapes d'application (a), (i), (b), (l) et (m) comprennent un trempé de la pièce de travail dans des solutions du matériau appliqué.

10. Procédé selon la revendication 2, dans lequel les étapes (a), (i) et (1) d'application du matériau comportent une déposition de vapeur du matériau sur la pièce de travail.

11. Procédé selon la revendication 2, dans lequel l'étape (a) comporte l'application de silicium sur la pièce de travail.

12. Procédé selon la revendication 11, dans lequel l'étape (i) comporte l'application d'un matériau sélectionné dans le groupe composé du nitrure de silicium et du dioxyde de silicium.

13. Procédé selon la revendication 2, dans lequel le faisceau d'exposition (12) est un faisceau d'électrons.

14. Procédé selon la revendication 2, dans lequel le faisceau d'exposition (12) est un faisceau d'ions.

15. Procédé selon la revendication 2, dans lequel le faisceau d'exposition (12) est un faisceau laser.

16. Procédé selon la revendication 2, dans lequel le faisceau d'exposition (12) est un faisceau de rayons X.

17. Procédé selon la revendication 2, dans lequel lesdites étapes de déplacement comportent les étapes de rotation de la pièce de travail autour d'un axe généralement perpendiculaire au faisceau (12), et du déplacement de la pièce de travail dans une direction parallèle à l'axe.

18. Procédé selon la revendication 1, dans lequel ledit dispositif semi-conducteur est un dispositif semi-conducteur à couche mince et dans lequel l'étape (a) comporte l'application d'une ou plusieurs couches d'un ou plusieurs matériaux semi-conducteurs à des surfaces de la pièce de travail.

19. Procédé selon la revendication 18, comportant en outre les étapes d'une application de matériau semi-conducteur sur les couches à des emplacements prédéterminés.

20. Procédé selon la revendication 19, dans lequel l'étape (e) comporte un déplacement linéaire de la pièce de travail dans une direction généralement parallèle à audit axe.

21. Procédé selon l'une des revendications 1 à 20 , dans lequel, dans l'étape (e), ledit substrat est déplacé dans le chemin dudit faisceau d'exposition, pour exposer ainsi une configuration prédéterminée de microcircuit dans le vernis de masquage.
